(19) Europäisches Patentamt
European Patent Office
Office européen des brevets

(11) **EP 2 770 807 A2**

(12) **EUROPEAN PATENT APPLICATION**

(43) Date of publication:
27.08.2014 Bulletin 2014/35

(51) Int Cl.:
*H05K 5/02* (2006.01)    *H05K 7/20* (2006.01)
*G06F 1/16* (2006.01)

(21) Application number: 14155422.0

(22) Date of filing: 17.02.2014

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: 20.02.2013 GB 201302999

(71) Applicant: **Amino Communications Limited**
**Cambridge CB4 4UQ (GB)**

(72) Inventor: **Westwood, James St. Valentine**
**Swavesey**
**Cambridgeshire CB24 4UQ (GB)**

(74) Representative: **EIP**
**Fairfax House**
**15 Fulwood Place**
**London WC1V 6HU (GB)**

(54) **Housing apparatus and method**

(57)    A housing is described which comprises and inner layer and an outer layer. The outer layer comprises a material with a lower thermal conductivity than the inner layer. The outer layer is configured to have a thermal insulance sufficient to enable the housing to be touched comfortably in use, when the surface temperature of the housing is higher than body temperature.

In one embodiment a receptacle for wireless communication components can be defined between the inner and outer layers, shielding the wireless communication components from interference from other components in the housing and allowing an antenna to be provided internal to the housing.

FIG. 1

EP 2 770 807 A2

**Description**

Technical Field

The present invention relates to a housing which allows heat generated by one or more heat sources within the housing to be transferred outside the housing. The housing can be for an electronics product, such as a consumer electronics product, and the one or more heat sources can be electronic, electrical or electro-mechanical components.

Background

Many products contain components that generate heat in use. The components may have a maximum operating temperature which should not be exceeded; examples include integrated circuits and hard disk drives. Therefore, when heat generating components are contained within a housing or case, means are provided to remove the heat from within the housing to outside the housing.

One way to remove heat from within a housing is to provide ventilation such as openings in the housing. The ventilation allows warmer air heated by components within the housing to escape and be replaced by cooler air from outside the housing. The ventilation can be fan assisted to improve its cooling performance.

Another way to remove heat from within a housing is to configure the housing itself to dissipate the heat, for example forming the housing from a material with high thermal conductivity. In such a construction heat is primarily transferred out of the housing through the walls of the housing itself. This can achieve cooling without requiring ventilation. The outer surface temperature of the housing temperature rises relative to the surroundings and heat is dissipated by a combination of radiation, convection and conduction from the surface of the housing.

When the housing itself is configured to dissipate heat, the rate at which heat is generated need only be a relatively small amount, for example 16W, before the surface of the housing feels uncomfortably hot if touched by a user. Surface temperature can be decreased by increasing the surface area, i.e. by increasing the size of the case. This increases cost of manufacture and shipping and makes the resultant product less convenient to locate in use.

US-2006/0182952 discusses an encapsulated thermally conductive electrically insulating assembly. It comprises a member having a thermal conductivity greater than 1 W/mK and a film encapsulating that member where the film has a thermal conductivity of less than 0.5 W/mK. The encapsulating film can comprise polyethylene (PE) or polyethylene terephthalate (PET) film.

Summary

According to a first aspect of the present invention, there is provided a housing configured to dissipate heat from one or more heat sources within the housing. The housing comprises an inner layer comprising a first material and an outer layer comprising a second material. The second material has a lower thermal conductivity than the first material. The outer layer is configured to have an overall thermal insulance of at least $2.5 \times 10^{-3}$ Km$^2$W$^{-1}$ at 20°C. It has been found that insulating the case with at least this level of insulance allows the housing to dissipate more heat while being more comfortable to touch than a comparable housing without the outer layer. This is the opposite of what would be expected - insulating a case would normally be expected to reduce heat loss from inside the housing and is not an obvious choice when increased heat transfer from within the housing is desired. A part of the inner layer and a part of the outer layer can be spaced apart from each other such that they define a receptacle for wireless communication components. This allows the housing to be adapted to have internal wireless communication components, such as one or more internal antennas, rather than requiring external components, such as antennas. A particular advantage is obtained when the inner layer comprises a metal because it will then shield the wireless communication components from electromagnetic interference from other components in the housing, such as a processor.

The insulance limits the thermal conduction of the outer surface so that, if it is hotter than skin temperature when touched, the portion of the surface touched is cooled locally rapidly and thereafter the rate at which heat is transferred to the touched portion of the surface is limited. This allows the outer surface to be comfortable to touch despite running at a temperature in the steady state which is higher than skin surface temperature. For example, it has been found that with these properties an outer surface which is between around 50°C and around 60 °C in the steady state can be touched without discomfort.

Overall thermal insulance refers to the insulation provided per unit area by a specific configuration of materials, it is the reciprocal of the heat transfer coefficient. It can be calculated by dividing a thickness of the material L by the value of thermal conductivity, k. Thermal insulance = L/k (k can be determined, for example, from a data table tabulating thermal conductivity for a particular material at a particular temperature or by experimentation.) For example if the outer layer comprises only the second material, the overall thermal insulance of the outer layer is the thickness of the outer layer divided by the thermal conductivity of the second material.

In another aspect of the invention, there is provided a housing configured to dissipate heat from one or more heat sources within the housing. wherein the housing comprises: an inner layer comprising a first material; an outer layer comprising a second material, the second material having a lower thermal conductivity than the first material; and an air gap between the inner layer and the outer layer. The air gap and the outer layer together are configured to have an overall thermal insulance of at least $2.5 \times 10^{-3}$ Km$^2$W$^{-1}$ at 20°C. Thus, this aspect provides the total thermal insulance by the combination of the insulance provided by the air gap and the outer layer. When one or more antennae are provided for wireless communication components they can be located in the air gap.

Air is an effective insulator and can increase the insulance of the outer layer without adding significant weight or bulk to the housing. An air gap can reduce material costs and bulk by allowing a thinner layer of the second material for the same overall thermal insulance provided by the second layer.

One way to provide an air gap is to define it by one or more raised areas provided on a surface of either or both of the first material or the second material. This spaces apart portions of the first and second material between the raised areas, defining the air gap. The raised areas can have any configuration, for example they can be linear or non-linear, ridges or protrusions, including raised, generally circular protrusions.

Air has a low thermal conductivity and so can provide a high insulance with a relatively short air gap. For example, the air gap can define a distance between the first material and the second material of less than or equal to 1 mm. The air gap can also define a distance less than or equal to 0.5 mm.

Further features can be provided for both the above described aspects. It can be desirable to place an upper limit on the overall thermal insulance of the outer layer, or the air gap and outer layer. The overall thermal insulance of the outer layer can be less than or equal to $3 \times 10^{-2}$ Km$^2$W$^{-1}$ at 20°C or less than or equal to $6 \times 10^{-2}$ Km$^2$W$^{-1}$ at 20°C. As the overall insulance increases the temperature inside the housing will increase so it can be desirable to limit the overall thermal insulance so that the internal temperature in the housing in use is acceptable.

The thermal conductivity of the first material can be at least 10 times higher than the second material, more preferably at least 50 or at least 100 times higher than the second material.

At least a part of an outer surface defined by the outer layer can be configured to have an emissivity of at least 0.5, more preferably at least 0.7 at 20°C. It has been found that an emissivity of at least this value enables the outer layer to radiate heat effectively, so that in a steady state the outer surface may actually radiate heat more effectively than a more thermally conductive material.

Emissivity is the constant used to determine heat transfer due to radiation in calculations using the Stefan-Boltzmann law when the item in question is not a perfect black body. It can be determined by consulting data tables tabulating emissivity for a particular material and surface treatment at a particular temperature. (There is not a significant difference in emissivity at 0 °C and at a room temperature of 20 °C). It can also be determined by measuring apparent temperature in comparison with a reference of a known emissivity. In this method, a part of a sample can be covered with a reference material of known emissivity (such as Scotch 33 black tape with an emissivity of 0.95), the sample is then uniformly heated. The emissivity of the sample can be determined by comparing the apparent heat of the reference material covering with the uncovered sample. For example, a non-contact thermometer may be used to measure the temperature of the covering reference material using its known emissivity of 0.95. The emissivity can then be determined by measuring the temperature of the uncovered sampled and adjusting the emissivity used by the thermometer to give the same temperature as the reference material. The adjusted emissivity is the emissivity of the sample.

The second material can be an insulating material, for example a material having a thermal conductivity of less than or equal to 1 Wm$^{-1}$K$^{-1}$ at 20°C. The second material can have a thermal conductivity of less than or equal to 0.5 Wm$^{-1}$K$^{-1}$ at 20°C. Thermal insulance is related to the reciprocal of thermal conductivity, therefore the lower the thermal conductivity of the material, the smaller the thickness of the material needed to provide a particular insulance.

The second material can comprise a plastics material. Plastics materials provide a combination of relatively high surface emissivity with relatively low thermal conductivity. Suitable plastics materials include Acrylonitrile Butadiene Styrene (ABS), Polystyrene, high impact polystyrene, Polycarbonate and composites of one or plastics materials, such as mixture of Polycarbonate and ABS.

The first material can be a thermally conductive material, for example a material having a thermal conductivity greater than or equal to 10 Wm$^{-1}$K$^{-1}$ at 20°C. The first material can have a thermal conductivity greater than or equal to 50 Wm$^{-1}$K$^{-1}$ at 20°C. This provides a relatively conductive inner layer which can help to even out heat distribution over the entire area of the housing and reduce hot spots. Examples of materials with such thermal conductivity include metals as well as other non-metallic materials with a relatively high thermal conductivity. The first material can comprise a metal. For example, the first material can be a metal or metal alloy. Aluminium or aluminium alloy provide a good balance between high conductivity and cost. For example, 6063 Aluminium alloy can be used, in particular 6063 aluminium alloy with T6 tempering.

In embodiments including an air gap, a part of the inner layer and a part of the outer layer can also be spaced apart from each other such that they define a receptacle for wireless communication components. When one or more antennae are provided for wireless communication components they can be located in the receptacle or in the air gap.

Using the air gap can allow a longer antenna, more antennae within the housing and/or give more scope for antenna placement for optimal performance.

An apparatus can comprise a housing as described above, with or without the optional features also described, and one or more components within the housing. The one or more components generate heat in operation. Such an apparatus can dissipate heat generated by the components in use through the housing while remaining comfortable to touch. For example, the components can be electronic, electrical or electro-mechanical components including integrated circuits and hard drives.

At least one thermal connection can be provided from the inner layer to at least one of the one or more components. This will improve the efficiency with which the housing can dissipate heat generated by the components because the overall thermal resistance to outside the housing is reduced. For example, a thermal connection could be a metal or heat pipe connection to a heat sink

The housing can be configured to have an outer surface temperature of between 25 and 150 °C, more preferably between 25 and 80 °C in the steady state when exposed to the surrounding air at an ambient temperature of 20 °C and the one or more components are in operation. A large number of factors will influence the design of the housing, including the power to be dissipated from components inside the housing and the size and shape of the housing. The outer surface temperature in the steady state can be determined by applying a temperature probe to the outer surface once the apparatus has been in operation for at least an hour.

An advantage of the housing in some embodiments is that all heat generated by components in operation can be dissipated passively; a fan is not required.

The housing can configured to dissipate at least 75% of the heat generated within the housing when exposed to the surrounding air at an ambient temperature of 20 °C and the one or more components are in operation. This allows the housing to dissipate the majority of heat from the components. In other embodiments the housing is configured to dissipate substantially all, or at least 90% of the heat generated within the housing is dissipated.

The housing and apparatus can be applied to a consumer electronics product. This allows heat to be dissipated from the consumer electronics product in an efficient and quiet manner.

According to another aspect of the invention, there is provided a method of increasing the heat that can be dissipated from a housing while allowing the housing to be touched comfortably, the method comprising insulating the housing with an outer layer having an overall thermal insulance of at least $3 \times 10^{-3}$ $Km^2W^{-1}$ at 20°C. Surprisingly, insulating the housing can allow it to dissipate more heat while remaining comfortable to touch.

In another aspect, there is provided an apparatus comprising one or more heat sources within a housing. The housing is configured to dissipate heat from the one or more heat sources. The housing comprises an inner layer comprising a first material; and an outer layer comprising a second material, the second material defining at least part of an outer surface of the housing. The second material has a lower specific thermal conductivity than the first material and is configured such that in use in the steady state the outer surface is at a temperature between 45 and 70 °C, and the outer surface can be touched without being perceived as hot.

In another aspect, there is provided a housing configured to dissipate heat from one or more heat sources within the housing, wherein the housing comprises a plurality of layers, with an inner layer having a thermal conductivity at least ten times higher than the thermal conductivity of an outer layer. The inner layer can have a thermal conductivity at least 50 times higher or at least 100 times higher than the outer layer in some embodiments.

Further features and advantages of the invention will become apparent from the following description of preferred embodiments of the invention, given by way of example only, which is made with reference to the accompanying drawings.

Brief Description of the Drawings

Figure 1 shows a diagrammatic representation of a housing according to an embodiment of the invention
Figure 2 shows a diagrammatic representation of a housing according to another embodiment of the invention;
Figure 3 shows a diagrammatic representation of an apparatus using the housing of Figure 1 or Figure 2;
Figure 4 shows detail from a diagrammatic representation of a cross section of a housing construction including an air gap according to another embodiment of the invention; and
Figure 5 shows a diagrammatic representation of a plan view of a material for use in the embodiment of Figure 4.

Detailed Description

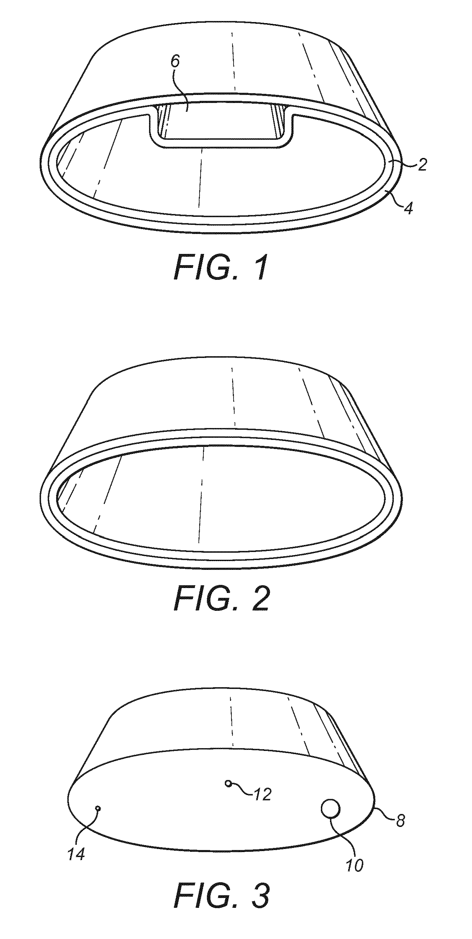

Figure 1 depicts an embodiment of a housing according to the present invention. The housing is configured to dissipate heat from components located within the housing (not shown). In Figure 1, the housing comprises a main component (shown) to which end caps are connected to create an enclosed housing. The housing is depicted without end caps so that the construction can be understood more clearly.

The housing comprises an inner layer 2 and an outer layer 4. The outer layer 4 has a lower thermal conductivity than the inner layer 2 and is configured as to insulate the inner layer 2. In this embodiment the inner layer 2 is 6063-T6 Aluminium and the outer layer 4 is high impact polystyrene. Other embodiments can use other materials. Thus, the inner layer has a relatively high thermal conductivity and will absorb heat generated by components within the housing and spread this over the area of the housing. The thickness of the inner layer is chosen to provide good heat distribution and thermal characteristics, for example it can be about 1mm to about 2.5mm thick, and in this embodiment it is 1.5mm thick. The outer layer 4 can be between 1mm and 2mm thick, and in this embodiment it is 1mm thick.

The outer layer 4 is configured to have a thermal insulance sufficient that the housing can be touched comfortably in the steady state, namely when components inside the case are generating heat which is dissipated through the case. Experimentation (described in more detail below) has found that an insulance of at least $2.5 \times 10^{-3}$ $Km^2W^{-1}$ at 20°C can provide this without unduly increasing temperatures within the case. Some specific material combinations that can be used to provide an insulance with at least value are set out in table 1 below:

Table 1

| Material | Thermal Conductivity $Wm^{-1}K^{-1}$ at 20°C | Thermal Insulance $Km^2W^{-1}$ at 20°C |
|---|---|---|
| Plastic, 1mm thick | 0.15 | $6.67 \times 10^{-3}$ |
| Plastic, 1mm thick | 0.3 | $3.33 \times 10^{-3}$ |
| Air 0.5mm and plastic 1mm thick | Air 0.03 Plastic 0.3 | $2.0 \times 10^{-2}$ ($1.67 \times 10^{-2}$ due to air, $3.33 \times 10^{-3}$ due to plastic. |

The outer layer 4 is also configured to provide an outer surface with good emissivity. This can be provided by inherent material characteristics by treating the surface in some way (for example by roughening the outer surface) or by painting or otherwise colouring the outer surface. Good emissivity is generally greater than 0.5 at 20 °C, although higher values can be beneficial. Example values of emissivity for different materials are given in Table 2 below.

Table 2

| Material | Emissivity (across all wavelengths at 20 °C) |
|---|---|
| Black plastic | 0.92 |
| White plastic | 0.87 |

The inner layer 2 and the outer layer 4 are generally closely adjacent to each other. However, Figure 1 depicts that in a portion of the housing the inner layer 2 and the outer layer 4 are spaced apart to define a receptacle 6 for wireless networking components (not shown). This allows the wireless networking components to be internal to the housing. It has further been found to improve the performance of the wireless networking components because the inner layer 2 shields them from electromagnetic interference arising from the operation of other components within the housing.

To facilitate construction, the housing comprises a first component open at each end which is then closed at each end by an end cap. Figure 1 depicts the first component without the end caps in place. The end caps can have a layered construction as described above or a simpler construction. An electrically conductive layer can be incorporated into the end caps. This can help improve the electromagnetic compatibility of the housing by limiting the radio frequency interference radiated out of the housing in use.

The inner layer 2 can be manufactured by any suitable method, such as extrusion or by bending a substantially planar piece of material. An advantage of the layered construction of this embodiment is that any blemishes introduced by manufacturing on the inner layer are hidden by the outer layer 4. It can be cheaper to obtain a good quality finish with the plastic comprising the outer layer 4 than with the metal comprising the inner layer 2.

The outer layer 4 can also be manufactured by any suitable method, such as injection moulding or extrusion. It has been found that the thermal performance of the housing is not significantly affected if the outer layer 4 is not perfectly in contact with the inner layer 2, allowing manufacturing tolerances to be reduced with a consequent reduction in the cost of manufacture.

Figure 2 depicts another embodiment, which is identical to Figure 1 except that there is no receptacle for wireless networking components.

Figure 3 depicts the embodiment of Figure 1 or 2 with an end cap 8 in place. The end cap 8 closes the housing.

As shown in Figure 1, the end cap is a front panel which can include one or more user input devices, such as operation button 10 and infrared receiver 12. The end panel can also include indicators, such as power light 14 or other form of display. A similar end panel can be added to the rear providing input and output connections to the components inside the housing. For example, if the housing is for a set top box the rear panel may provide an audio visual output, such as HDMI, for connection to a television. Further connections can also be provided, for example antenna connections and wired networking interfaces.

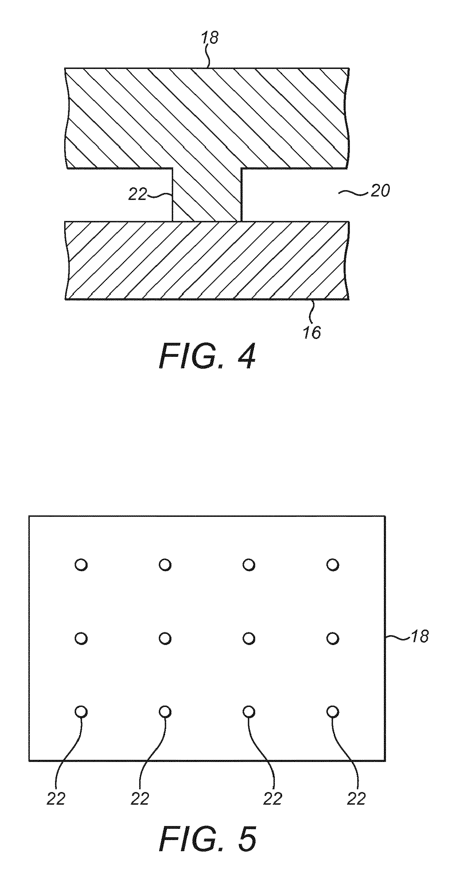

Referring now to Figure 4, a detail cross section is shown of an embodiment which is the same Figure 1 except that an air gap 20 is provided between an inner layer 16 and an outer layer 18. The air gap is defined by providing the material of the outer layer 18 with a protrusion 22 that contacts the inner layer and spaces the rest of the outer layer 18 from the inner layer 16. In this embodiment the protrusion 22 extends about 0.5mm above the surface of the material comprising the outer layer 18. Providing an air gap can increase the insulance of the outer layer with reduced bulk and cost compared with using a thicker material to make up the outer layer 18.

Figure 5 is a plan view of the outer layer 18 shown in Figure 4. It depicts how a plurality of protrusions 22 are provided to define the air gap. Although Figure 5 depicts a regular arrangement of generally circular projections, any other suitable arrangement can be used, including irregular arrangements and other shapes of projections, such as linear projections.

There is a large choice of materials that can be used in alternative embodiments. For example the inner layer can comprise any material with a thermal conductivity greater than or equal to 10 $Wm^{-1}K^{-1}$ at 20°C. For example steel may be a cheaper alternative to Aluminium. However, a higher thermal conductivity will reduce the resistance of the second layer to heat flow reducing internal temperature (because there is smaller temperature drop across the inner layer) and improve the even distribution of heat through the housing. Likewise any insulating material can be used in the outer layer. Both the inner and outer layer can have composite structures comprising more than one material. One such composite structure is described above for the outer layer with reference to the air gap of Figure 4. Other composite structures are possible, for example combining solid and foamed materials in the outer layer.

Examples of specific housing configurations will now be described to assist in understanding the invention.

In a first example, a prior art housing configuration was prepared using a single layer of 6063-T6 aluminium 1.5mm thick and painted black. The housing is approximately 200mm wide, 160mm deep and 45mm high. A heat source generating approximately 16.4W of heat is provided inside the housing. The heat source was turned on and the apparatus left to reach a steady state. Surface temperature was measured by a contact temperature probe to be approximately 49.4 °C in the steady state.

This prior art housing was then insulated with a 1mm thick layer of high impact polystyrence, held in place by zip ties to create the layered construction of the invention. The heat source was activated and the apparatus left to reach the steady state. When in this state surface temperature was measured by a contact temperature probe to be approximately 48.7 °C. The internal case was found to be only 1 to 2 °C higher with the plastic in place. The high impact polystyrene layer therefore has minimal impact on internal temperature and actually reduces external surface temperature. It was also observed qualitatively that the high impact polystyrene surface felt cooler than the small decrease in surface temperature suggested.

In this example, the slight decrease in surface temperature can be explained by the surface of the high impact polystyrene layer having higher emissivity than the painted aluminium. (For comparison, black aluminium has an emissivity of about 0.8 at 20°C at room temperature, less than the examples in Table 2 above.) Approximately 65% of the heat dissipated by the housing is through black body radiation, with the remainder by convection and conduction. Thus, an improvement an emissivity can improve overall heat transfer to the surroundings and lower the surface temperature required to dissipate the same power. In this case the power dissipated by radiation can be estimated by the Stefan-Boltzmann law expressed in the form:

$$P = A\varepsilon\sigma T^4$$

In this equation P is the power in watts radiated, A is the Area, $\varepsilon$ is the Emissivity and T is absolute temperature. The relationship allows a relatively small change in temperature to have a large effect on the power radiated by the $T^4$ term. Total power radiated can be determined by calculating P for a particular surface temperature and then subtracting the power absorbed from the surroundings (using the same equation but with the room temperature rather than the surface temperature).

In another example, the effect of including an air gap in the outer layer was investigated. An air gap of approximately 0.5 mm was introduced between the inner layer and the outer layer in the example discussed above. The internal temperature was observed to rise by approximately 6 °C and the surface of the case was observed to feel cooler when touched. This decrease in perceived temperature can be explained by the increased insulation from the air gap limiting heat transfer to the area cooled by contact with a finger.

In another example a housing with dimensions of 114mm wide by 90mm deep by 35 mm high was prepared with housing comprising an inner layer of 1.5mm thick aluminium and an outer layer of 1mm thick high impact polystyrene. A receptacle approximately 30mm wide by 90mm long by 10mm high was formed between the inner and outer layer to hold wireless networking components. A heat source generating approximately 8W was provided inside the housing. The heat source was turned on and the housing left to reach the steady state.

Surface temperature of the housing was measured by two contact temperature probes in different positions on the housing. In the steady state, these probes provided readings of 57.9 °C and 58.0 °C respectively. One of the probes was then touched and the surface temperature was observed to drop, demonstrating that the insulance of the outer layer was sufficient for it to be cooled by the finger and then maintain that temperature because the insulance limits the rate at which heat can be transferred from inside the case and the surrounding portions of the second layer. The housing was observed to feel comfortable to touch. After ten seconds the temperature probes read 33.0 °C where the surface was touched and 56.9 °C in the untouched portion. Therefore, contrary to what might be expected, insulating the case enabled it to continue to dissipate heat while feeling cooler to touch.

In a further example, measurements were obtained to compare the impact of the invention on the perceived and actual surface temperature of a housing over a longer period of time. A housing was constructed from 2mm thick 6063-T6 aluminium with dimensions of 114mm wide by 90mm deep by 35 mm high, a heat source generating 8W in operation was provided inside the housing. A contact temperature probe was provided on the surface of the housing. The heat source was activated and the surface temperature recorded when a steady state was reached. The contact temperature probe was when touched to measure the effect of touching on surface temperature. The surface temperature as measured by the temperature probe was recorded after touching for ten seconds and after touching for sixty seconds. The housing was then insulated with a 1mm thick high impact polystyrene outer layer and the measurements repeated. A 0.5 mm air gap was then provided between the aluminium and the high impact polystyrene and the measurements repeated. The results are given in Table 3 below.

Table 3

| Housing Configuration | Steady State Surface Temperature (°C) | Surface temperature after touching for 10s (°C) | Surface temperature after touching for 60s (°C) |
|---|---|---|---|
| 2mm thick Al | 55.4 | 50.2 | No result - Too painful to touch for 60s |
| 2mm thick Al, 1mm high impact polystyrene outer layer | 53.5 | 40.7 | 44.1 |
| 2mm thick Al, 0.5mm air gap, 1mm high impact polystyrene outer layer | 54.0 | 40.3 | 40.1 |

The above embodiments and examples are to be understood as illustrative examples of the invention. Further embodiments of the invention are envisaged. For example, it can be appreciated that the choice of particular housing shape and dimensions is potentially limitless and will depend on a specific application. The principle of the invention, insulating a housing to allow it to continue to dissipate heat from inside while feeling cooler to touch, can be applied to any housing configuration. It is to be understood that any feature described in relation to any one embodiment may be used alone, or in combination with other features described, and may also be used in combination with one or more features of any other of the embodiments, or any combination of any other of the embodiments. Furthermore, equivalents and modifications not described above may also be employed without departing from the scope of the invention, which is defined in the accompanying claims.

Claims

1.   A housing configured to dissipate heat from one or more heat sources within the housing, wherein the housing comprises:

an inner layer comprising a first material; and
an outer layer comprising a second material, the second material having a lower thermal conductivity than the first material;

wherein the outer layer is configured to have an overall thermal insulance of at least $2.5 \times 10^{-3}$ Km$^2$W$^{-1}$ at 20°C; and wherein a part of the inner layer and a part of the outer layer are spaced apart from each other and define a receptacle for wireless communication components.

2. A housing configured to dissipate heat from one or more heat sources within the housing, wherein the housing comprises:

an inner layer comprising a first material;
an outer layer comprising a second material, the second material having a lower thermal conductivity than the first material; and
an air gap between the inner layer and the outer layer;
wherein the air gap and the outer layer together are configured to have an overall thermal insulance of at least $2.5 \times 10^{-3}$ Km$^2$W$^{-1}$ at 20°C.

3. A housing according to claim 3, wherein the air gap and the outer layer together are configured to have an overall thermal insulance value less than or equal to $6 \times 10^{-2}$ Km$^2$W$^{-1}$ at 20°C.

4. A housing according to claim 2 or 3, wherein the air gap is defined by one or more raised areas provided on a surface of either or both of the inner layer or the outer layer.

5. A housing according to claim 2, 3 or 4, wherein the air gap defines a distance between the inner layer and the outer layer of less than 1mm.

6. A housing according to any one of claims 2 to 5, wherein a part of the inner layer and a part of the outer layer are spaced apart from each other and define a receptacle for wireless communication components.

7. A housing according to any one of the preceding claims, wherein at least a part of an outer surface defined by the outer layer is configured to have an emissivity of at least 0.5 at 20°C.

8. A housing according to any one of preceding claims, wherein the second material has a thermal conductivity less than or equal to 1 Wm$^{-1}$K$^{-1}$ at 20°C.

9. A housing according to claim 8, wherein the second material comprises a plastics material.

10. A housing according to any one of the preceding claims, wherein the first material has a thermal conductivity greater than or equal to 10 Wm$^{-1}$K$^{-1}$ at 20°C.

11. A housing according to claim 10, wherein the first material comprises a metal.

12. An apparatus comprising:

a housing according to any one of the preceding claims; and
one or more components within the housing, wherein the one or more components generate heat in operation.

13. An apparatus according to claim 12, wherein the housing comprises at least one thermal connection from the inner layer to at least one of the one or more components.

14. An apparatus according to claim 12 or 13, wherein the housing is configured to have an outer surface temperature of between 35 and 80 °C in the steady state when exposed to the surrounding air at an ambient temperature of 20 °C and the one or more components are in operation.

15. An apparatus according to any one of claims 12 to 14, wherein the housing is configured to dissipate at least 75% of the heat generated within the housing when exposed to the surrounding air at an ambient temperature of 20 °C and the one or more components are in operation.

FIG. 1

FIG. 2

FIG. 3

*18*

*22*~

~*20*

*16*

# FIG. 4

~*18*

*22*        *22*        *22*        *22*

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060182952 A